Europäisches Patentamt

European Patent Office

Office européen des brevets

(19)

(11) **EP 0 691 738 B1**

(12) **FASCICULE DE BREVET EUROPEEN**

(45) Date de publication et mention
de la délivrance du brevet:
**13.06.2001 Bulletin 2001/24**

(51) Int Cl.[7]: **H03H 7/40**

(21) Numéro de dépôt: **95401613.5**

(22) Date de dépôt: **05.07.1995**

(54) **Antenne demi-boucle à accord automatique rapide**

Halbschleifenantenne mit schneller selbsttätiger Abstimmung

One-half loop antenna with automatic quick tuning

(84) Etats contractants désignés:
**BE DE FR GB**

(30) Priorité: **06.07.1994 FR 9408341**

(43) Date de publication de la demande:
**10.01.1996 Bulletin 1996/02**

(73) Titulaire: **Chelton Antennas**
**91410 Dourdan (FR)**

(72) Inventeurs:
• **Gouin, Jean-Pierre**
**F-94440 Santeny (FR)**
• **Volckringer, Pierre-Olivier**
**F-94260 Fresnes (FR)**

(74) Mandataire: **Schrimpf, Robert et al**
**Cabinet Regimbeau**
**20, rue de Chazelles**
**75847 Paris cedex 17 (FR)**

(56) Documents cités:
EP-A- 0 210 746        FR-A- 2 346 901
FR-A- 2 553 586        FR-A- 2 573 940
US-A- 4 343 001        US-A- 4 486 722

• TELECOMMUNICATIONS AND RADIO
ENGINEERING, vol.46, no.12, Décembre 1991,
NEW YORK US pages 73 - 75 V. A. GALKIN
'Automatic antenna matching devices for
portable radio stations'
• ELECTRONICS & WIRELESS WORLD, vol.92,
no.1599, Janvier 1986, LONDON GB pages 17 -
22 C. E. COOPER 'Remotely tunable antennas for
frequency-hopping'

EP 0 691 738 B1

## Description

La présente invention concerne une antenne à accord automatique, à relier à un poste émetteur-récepteur apte à émettre successivement une suite de fréquences déterminées.

On connait une antenne comprenant un élément rayonnant du type boucle ou demi-boucle et des moyens d'accord pour l'accorder sur une fréquence d'émission ou de réception du poste (FR-A-2 553 586). Dans cette antenne, les moyens d'accord comportent un condensateur variable et un mécanisme d'entraînement couplé au conden-sateur pour faire évoluer la capacité de ce dernier vers une valeur correspondant à l'accord de l'antenne, pour une fréquence donnée d'émis-sion ou de réception du poste. L'inconvénient de ce type d'asservissement est sa lenteur, qui ne permet pas un suivi de la fréquence pour des modes de transmission du poste dits à évasion de fréquence, dans lesquels la fréquence est susceptible de varier rapidement. La publication EP-A-0 210 746 décrit une antenne qui comprend un élément rayonnant, des moyens d'accord pour l'accorder dans une des gammes HF, VHF, UF sur l'une quelconque des fréquences du poste, ces moyens d'accord comportant un ensemble de condensateurs et des moyens de commutation associés à ces condensateurs, pour mettre en service la combinaison particulière de condensateurs correspondant à la valeur de capacité conduisant à l'accord de l'élément rayonnant à ladite fréquence.

Selon cette publication, les condensateurs sont combinés avec des bobines d'induction dans des combinaisons qui correspondent chacune à l'une des fréquences.

L'invention vise à remédier à l'inconvénient des antennes connues, afin de pouvoir effectuer la transmission avec évasion de fréquence dans l'une des gammes HF. VHF. UHF.

On y parvient selon l'invention avec une antenne telle que definie dans la revendication 1.

Les publications FR-A-2 573 940 FR-A-2 346 901 et EP-A-0 210 746 décrivent des dispositifs comportant une antenne travaillant dans des bandes de fréquences très étendues mais aucun de ces dispositifs ne comporte une antenne telle que définie ci-dessus et présentant les avantages procurés par cette antenne.

De préférence, les moyens de commutation comportent des relais pour l'accord de l'élément rayonnant lorsque l'antenne fonctionne en émission et des diodes PIN pour l'accord de l'élément rayonnant lorsque l'antenne fonctionne en réception. On garantit ainsi une grande fiabilité de l'antenne en mode réception, le passage de la puissance lors de l'émission et une grande rapidité de la commutation en réception.

Les publications TELECOMMUNICATIONS AND RADIO ENGINEERING (Vol. 46, n° 12, DEC. 1991, pages 73-75, New York) et US-A-4 486 722 décrivent l'utilisation de diodes PIN dans des circuits d'antenne mais la présente invention ne revendique cette utilisation que dans le contexte spécifique de l'antenne de la présente invention.

L'antenne selon l'invention permet avantageusement, lorsqu'elle est installée sur un véhicule automobile, d'émettre et de recevoir en roulant.

D'autres caractéristiques et avantages de la présente invention apparaîtront à la lecture de la description qui suit, d'un exemple de réalisation non limitatif de l'invention, et à l'examen du dessin sur lequel :

- la figure 1 représente, de façon schématique, un élément rayonnant de type demi-boucle,
- la figure 2 est un schéma général d'une antenne à accord rapide conforme à l'invention.
- la figure 3 est une courbe montrant la valeur de capacité à mettre en circuit pour obtenir l'accord de l'élément rayonnant, en fonction de la fréquence,
- la figure 4 indique, de façon générale, la succession des étapes mises en oeuvre pour mémoriser les valeurs de combinaisons de condensateurs correspondant à l'accord de l'élément rayonnant pour la suite de fréquences déterminées envoyées par le poste à l'antenne lors de la phase d'apprentissage,
- la figure 5 est un chronogramme montrant un signal de demande de fréquence envoyé par l'antenne au poste, un signal de synchronisation envoyé en retour par le poste, avant un temps mort d'émission, et un signal d'émission,
- la figure 6 est un organigramme illustrant le déroulement de la phase d'apprentissage de l'antenne,
- la figure 7 montre l'écart (en pF), en fonction de la fréquence, entre la capacité calculée par le circuit électronique et la capacité théorique correspondant à l'accord de l'antenne,
- la figure 8A montre l'évolution de la capacité totale pour des combinaisons successives de condensateurs mises en service, les valeurs de capacité des condensateurs correspondant aux valeurs nominales avec une tolérance nulle,
- la figure 8B montre l'évolution du rapport d'ondes stationnaires en fonction de la fréquence pour des combinaisons successives de condensateurs mises en service, ces condensateurs ayant des valeurs de capacité correspondant aux valeurs nominales avec tolérance nulle,
- la figure 9A montre l'évolution de la capacité pour des combinaisons successives de condensateurs mises en service, les valeurs de capacité des condensateurs correspondant aux valeurs nominales à une tolérance de fabrication près,
- la figure 9B montre l'évolution du rapport d'ondes stationnaires en fonction de la fréquence pour des combinaisons successives de condensateurs mises en service, les valeurs de capacité de ces condensateurs étant les mêmes que dans le cas de la figure 9A, la discontinuité observée étant due à la valeur de capacité des condensateurs employés,

- la figure 10A montre l'évolution de la capacité pour des combinaisons successives de condensateurs mises en service, avec chevauchement dû à la valeur de capacité des condensateurs employés,

- la figure 10B montre l'évolution du rapport d'ondes stationnaires en fonction de la fréquence pour des combinaisons successives de condensateurs mises en service, les valeurs de capacité de ces condensateurs étant les mêmes que dans le cas de la figure 10A,

- les figures 11A et 11B illustrent la transformation effectuée pour éviter le recouvrement des valeurs de capacité lors de la mise en service de combinaisons successives de condensateurs.

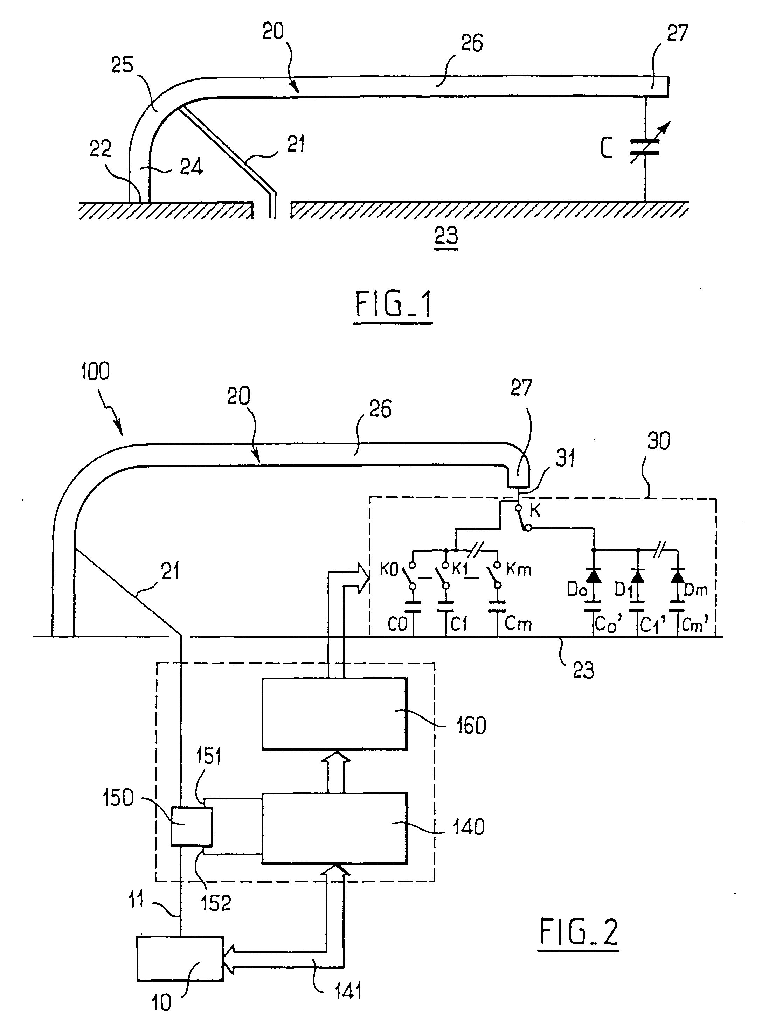

On a représenté sur la figure 1 un élément rayonnant 20 du type demi-boucle, connu en lui-même. Cet élément rayonnant 20 est disposé en regard d'un réflecteur 23 métallique et se présente par exemple sous la formed'un monopole replié dans un plan perpendiculaire à ce réflecteur 23. L'élément rayonnant 20 présente une portion courte 24 se raccordant, à une extrémité, au plan réflecteur 23, perpendiculairement à celui-ci, et à l'autre extrémité par un coude à angle droit 25, à une portion longue 26 s'étendant parallèlement au plan réflecteur 23. L'alimentation de l'élément rayonnant 20 se fait de façon connue en soi au moyen d'une ligne 21 électriquement reliée à la portion courte 24 en un point dont la position est choisie de manière à réaliser l'adaptation en impédance de l'élément rayonnant. L'extrémité libre 27 de la portion longue 26 est électriquement reliée, par l'intermédiaire de moyens d'accord se comportant comme un condensateur de valeur de capacité C, au plan réflecteur 23. Le monopole replié constitue une inductance qui est associée aux moyens d'accord pour former un circuit oscillant.

On a représenté sur la figure 2 une antenne à accord rapide 100 conforme à l'invention, comprenant des moyens d'accord 30 reliés en 31 à l'extrémité libre 27 de la portion longue 26 pour accorder l'élément rayonnant 20 sur une fréquence f d'émission ou de réception d'un poste émetteur-récepteur 10.

Les moyens d'accord comportent un premier ensemble de condensa-teurs $C_0$, $C_1$, ..., $C_m$, pour l'accord de l'élément rayonnant en émission et un deuxième ensemble de condensateurs $C_0'$, $C_1'$, ..., $C_m'$ pour l'accord de l'élément rayonnant en réception. Les valeurs nominales des condensateurs $C_0$, $C_i$, ..., $C_m$ sont respectivement égales aux valeurs nominales des condensateurs $C_0'$, $C_1'$, ..., $C_m'$. Les condensateurs du premier ensemble de condensateurs $C_0$, $C_1$, ..., $C_m$ sont reliés chacun en série avec un moyen de commutation associé constitué par un relais métallique. La fermeture des relais permet de mettre en parallèle les condensateurs associés aux relais. Les différents relais sont respectivement référencés $K_0$, $K_1$, ..., $K_m$ pour les condensateurs $C_0$, $C_1$, ..., $C_m$. Les relais $K_0$, $K_1$, ..., $K_m$ sont destinés à être commutés de manière à mettre en circuit, entre le point 31 et la masse électrique du réflecteur 23, une combinaison particulière M(f) de condensateurs correspondant à la valeur de capacité C(f) donnant l'accord de l'élément rayonnant à une fréquence donnée f d'émission du poste 10. La combinaison M(f) est un mot binaire de m+ 1 bits, la mise à 1 d'un bit correspondant à la fermeture d'un relais, la mise à 0 de ce bit correspondant à l'ouverture du relais. Par exemple, pour m = 1, le mot binaire 11 correspond à la fermeture des relais $K_0$ et $K_1$ respectivement associés aux condensateurs $C_0$ et $C_1$, le mot 10 correspond à la fermeture de $K_1$ et à l'ouverture de $K_0$, etc.... La valeur de $C_0$ correspond à la plus petite valeur de capacité pouvant être mise en circuit, définit la résolution des moyens d'accord et la plus haute fréquence d'accord de l'antenne. La mise en service de tous les condensateurs $C_0$, $C_1$, ..., $C_m$ définit la plus basse fréquence d'accord de l'antenne. Dans l'exemple décrit, pour la gamme HF, $C_0$ = 1,5 pF, $C_0 + C_1 + ... + C_m$ = 3 778,5 pF.

Les condensateurs du deuxième ensemble de condensateurs $C_0'$, $C_1'$, ..., $C_m'$ sont respectivement reliés en série avec des diodes PIN $D_0$, $D_1$, ..., $D_m$, à commuter pour mettre en service la combinaison de condensateurs $C_0'$, $C_1'$, ..., $C_m'$ correspondant à la valeur de la capacité donnant l'accord de l'élément rayonnant 20 pour une fréquence de réception f du poste 10.

Un relais K permet de relier électriquement l'extrémité libre 27 de la portion longue 26 de l'élément rayonnant 20 au deuxième ensemble de condensateurs $C_0'$, $C_1'$, ..., $C_m'$ lorsque le mode de transmission sélectionné est la réception, c'est-à-dire lorsque $K_0$, $K_1$, ..., $K_m$ sont ouverts. En émission, K est ouvert.

Les moyens de commutation associés au premier ensemble de condensateurs et au deuxième ensemble de condensateurs sont commandés, par l'intermédiaire d'un circuit de puissance 160 approprié, par un circuit électronique 140. Ce dernier est agencé pour calculer la combinaison M(f) de condensateurs à mettre en circuit entre l'élément rayonnant 20 et le réflecteur 23 pour toute fréquence f d'émission ou de réception du poste 10. Le circuit électronique 140 est relié par une liaison électrique 141 au poste émetteur-récepteur 10. Cette liaison électrique 141 est utilisée dans le sens de l'antenne vers le poste lors d'une phase d'apprentissage de l'antenne et dans le sens du poste vers l'antenne lors du fonctionnement normal du poste en émission ou en réception. Le poste indique alors à l'antenne sa fréquence f d'émission ou de réception et l'antenne s'accorde automatiquement sur celle-ci. La liaison électrique 141 est dans l'exemple décrit une liaison série.

L'entrée/sortie de la ligne haute fréquence 11 du poste émetteur-récepteur 10 est reliée, par l'intermédiaire d'un coupleur bidirectionnel (30 dB par exemple) référencé 150, à la ligne d'alimentation 21 de l'élément rayonnant 20. On recueille de façon connue en soi sur des sorties 151 et 152 du coupleur bidirectionnel 150 des signaux dont la comparaison des amplitudes permet au circuit électronique 140 de calculer, pour une fréquence d'émission ou de réception f du poste donnée, le rapport d'ondes stationnaires de l'élément rayonnant afin d'en déduire la qualité d'accord obtenu.

Conformément à l'invention, la combinaison M(f) de condensa-teurs à mettre en service pour obtenir la valeur de capacité permettant d'accorder l'élément rayonnant 20 à une fréquence f d'émission ou de réception du poste est calculée par le circuit électronique 140 à partir d'une suite de valeurs de capacités $C(f_0)$, $C(f_1)$, ..., $C(f_i)$ préalablement déterminées lors de la phase d'apprentissage de l'antenne. Ces valeurs de capacité correspondent respectivement à l'accord de l'élément rayonnant 20 pour une suite de fréquences connues $f_0$, $f_1$, ..., $f_i$ successivement demandées par l'antenne au poste 10 lors de la phase d'apprentissage.

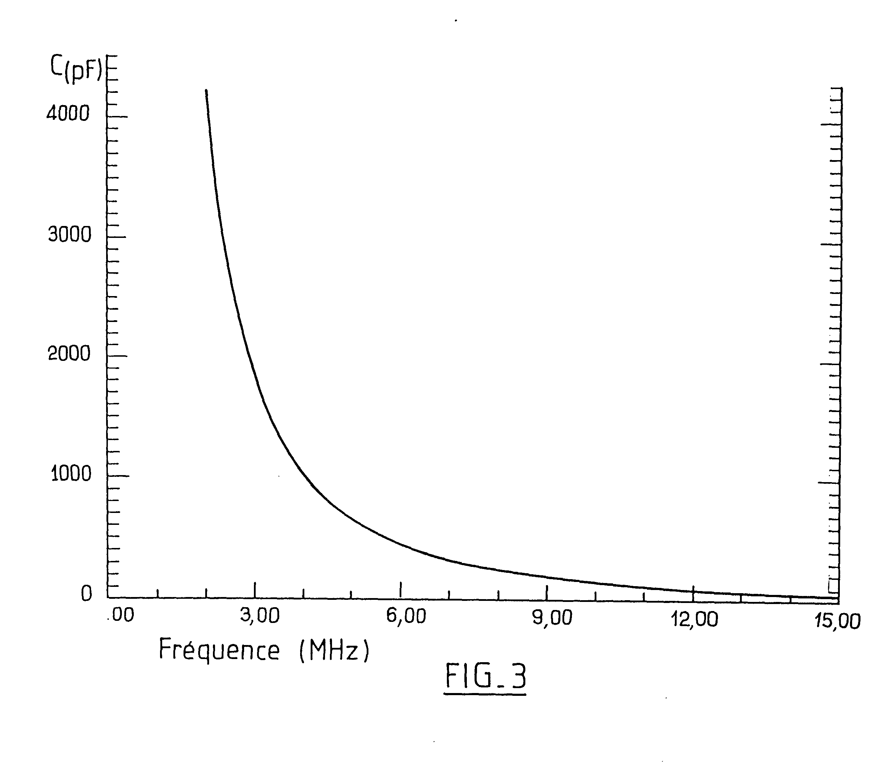

On a représenté sur la figure 3 la capacité théorique à mettre en service pour obtenir l'accord de l'élément rayonnant, en fonction de la fréquence.

Cette courbe qui est monotone (décroissance de C en fonction de la fréquence) est modélisée par le circuit électronique 140 sous forme d'une suite de polynômes Cj

$$Cj\,(f) = \frac{A_j}{f^2} + \frac{B_j}{f^3}$$

Les constantes $A_j$ et $B_j$ sont déterminées expérimentalement lors de la phase d'apprentissage par la connaissance des combinaisons $M(f_j)$ de condensateurs à mettre en circuit (donc par la connaissance des valeurs de capacité $C(f_j)$ correspondant à ces combinaisons) afin d'obtenir le meilleur accord de l'élément rayonnant 20 pour chacune des fréquences $f_0$, $f_1$, ..., $f_i$.

On obtient des systèmes d'équations

$$M(f_0) \rightarrow \qquad C(f_0) = \frac{A_0}{f_0^{\,2}} + \frac{B_0}{f_0^{\,3}} = C^0(f_0)$$

$$M(f_1) \rightarrow \qquad C(f_1) = \frac{A_0}{f_1^{\,2}} + \frac{B_0}{f_1^{\,3}} = C^0(f_1)$$

$$M(f_1) \rightarrow \qquad C(f_1) = \frac{A_1}{f_1^{\,2}} + \frac{B_1}{f_1^{\,3}} = C^1(f_1)$$

$$M(f_2) \rightarrow \qquad C(f_2) = \frac{A_1}{f_2^{\,2}} + \frac{B_1}{f_2^{\,3}} = C^1(f_2)$$

$$M(f_i) \rightarrow \qquad C(f_i) = \frac{A_i}{f_i^{\,2}} + \frac{B_i}{f_i^{\,3}} = C^j(f_i)$$

Chaque couple $A_j$, $B_j$ est obtenu en résolvant un système de deux équations à deux inconnues. La résolution de ces systèmes permet de déterminer les valeurs des constantes $A_0$, $B_0$, $A_1$, $B_1$, ..., $A_i$, $B_i$.

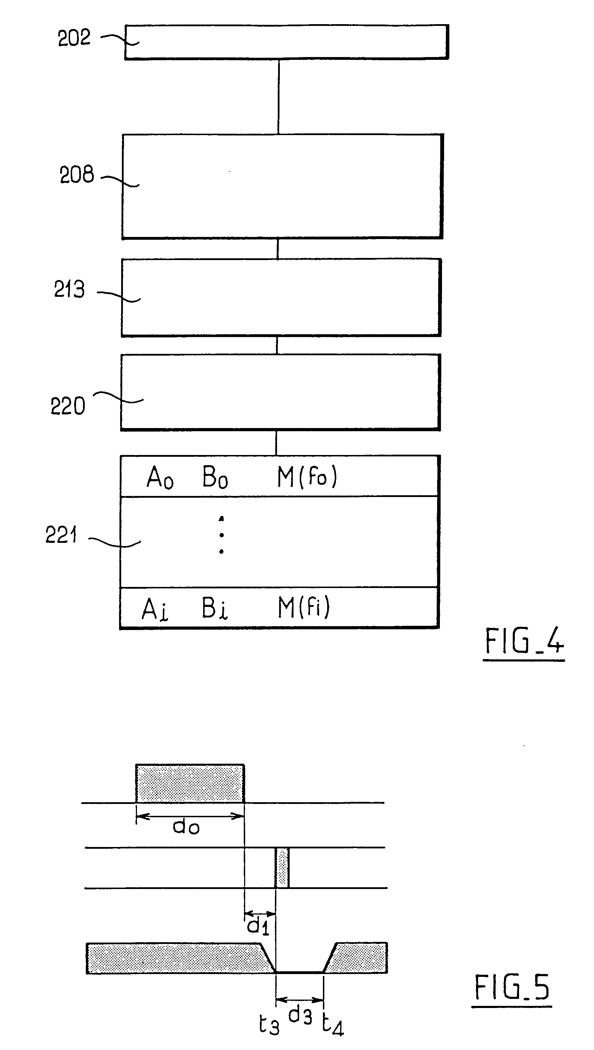

La phase d'apprentissage de l'antenne permettant de déterminer les valeurs $C(f_0)$, ..., $C(f_i)$ conduisant au calcul des constantes $A_0$, $B_0$, $A_1$, ..., $A_i$, $B_i$, est résumée sur le tableau de la figure 4. Chaque fréquence de la suite de fréquences $f_0$, $f_1$, ..., $f_i$ est successivement envoyée par le poste 10, sur la demande du circuit 140 lors de l'étape 202, à l'élément rayonnant 20. L'émission a lieu à puissance réduite, après un temps mort d'émission précédé d'un signal de synchronisation, ce temps mort étant mis à profit pour agir sur les moyens de commutation. On a représenté sur le chronogramme de la figure 5 la transmission par l'antenne pendant la durée $d_0$, en mode série, de la fréquence demandée au poste 10. Pendant la durée $d_1$ qui suit la réception de cette demande de fréquence, le poste 10 interrompt son émission s'il était en train d'émettre puis émet, à l'instant $t_2$, un signal de synchronisation annonçant l'arrivée d'un temps mort de durée $d_3$ pendant lequel s'effectuera le changement de la combinaison de condensateurs mise en service. Au terme de ce temps mort, le poste 10 émet, à l'instant $t_4$, à la fréquence demandée précédemment par l'antenne. Une première combinaison de condensateurs est calculée lors de l'étape 208 à partir de constantes de

prépositionnement A$_0$', B$_0$', ..., A$_i$', B$_i$', implantées dans une mémoire morte du circuit électronique 140 lors de la fabrication de l'antenne. Ces constantes permettent d'obtenir un accord approximatif de l'élément rayonnant, qui va être affiné lors des itérations suivantes. Par itération, lors de l'étape 213, la capacité mise en service est modifiée jusqu'à ce que l'on obtienne un rapport d'ondes stationnaires minimum, représentatif du meilleur accord possible pour l'élément rayonnant 20 compte tenu de la résolution des moyens d'accord. La combinaison de condensateurs conduisant à ce meilleur accord est mémorisée lors de l'étape 220 et la fréquence suivante de la suite f$_0$, ..., f$_i$ est demandée au poste 10 (retour à l'étape 202). Après avoir mémorisé toutes les combinaisons M(f$_0$), ..., M(f$_i$) de condensateurs correspondant à l'accord de l'élément rayonnant 20 pour les différentes fréquences f$_0$, f$_1$, ..., f$_i$, on calcule lors d'une étape ultérieure en 221 les constantes A$_0$, B$_0$, A$_1$, B$_1$, ..., A$_i$, B$_i$.

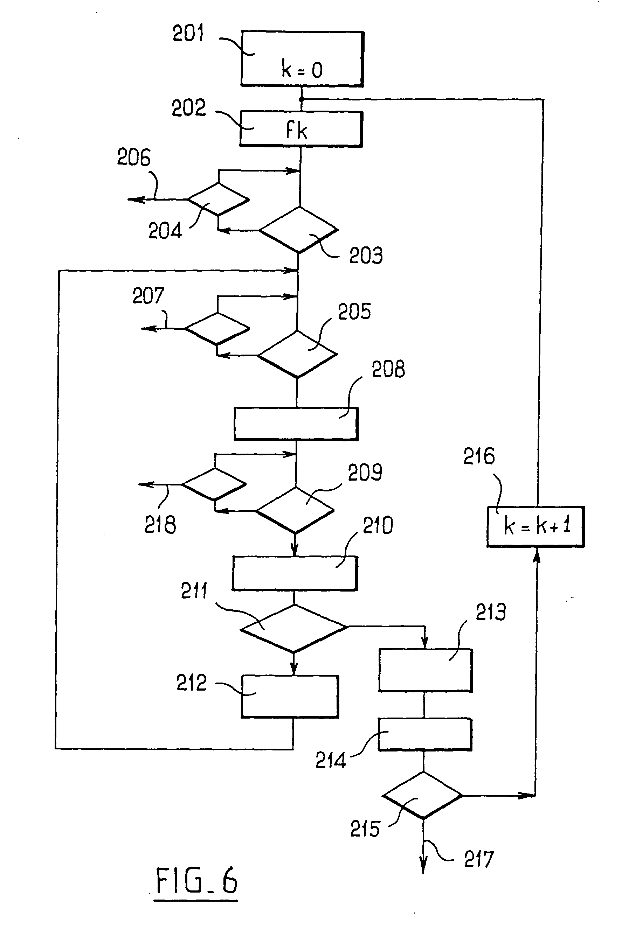

On a représenté sur la figure 6 l'organigramme conduisant à la mémorisation des valeurs M(f$_0$), ..., M(f$_i$).

La phase d'apprentissage débute sur commande de l'utilisateur ou peut s'effectuer automatiquement à la mise sous tension de l'antenne. Une variable itérative k est initialisée à l'étape 201. Le circuit électronique 140 commande, lors de l'étape 202, par l'intermédiaire de la liaison électrique 141, le poste 10 pour l'envoi d'une fréquence f$_k$ par le poste. Le circuit électronique 140 recherche ensuite, pendant un temps de recherche fixé à 500 ms dans l'exemple décrit, lors du test 203, le signal de synchronisation émis par le poste 10 avant chaque temps mort d'émission. En cas de présence de ce signal de synchronisation, le circuit électronique 140 passe à l'étape suivante 205. L'absence prolongée de ce signal de synchronisation provoque l'envoi en 206 d'un signal d'erreur indiquant qu'un accord de l'antenne est impossible. Le poste 10 ne commence à émettre qu'après la fin du temps mort suivant la demande d'émission sur une fréquence donnée par l'antenne, qui a une durée fixée à 5 ms dans l'exemple de réalisation décrit. Cette durée est suffisante pour permettre la commutation des relais. La présence de haute fréquence est testée en 205. En cas d'émission continue par le poste, c'est-à-dire en cas d'absence de temps mort d'émission pendant une durée supérieure à une valeur fixée à 500 ms dans l'exemple décrit, un signal d'erreur est envoyé en 207 indiquant que l'accord est impossible, faute de pouvoir agir sur les moyens de commutation pendant un temps mort d'émission. Lorsque le temps mort suivant la demande de fréquence est détecté, le circuit passe à l'étape 208 et une combinaison particulière de condensateurs est commutée. Cette combinaison est déterminée en fonction d'un algorithme de recherche programmé dans une mémoire du circuit électronique 140. Cet algorithme peut être par exemple une méthode du gradient. La présence de haute fréquence est testée à l'étape 209, car elle est nécessaire pour calculer lors de l'étape suivante 210, le rapport d'ondes stationnaires. En cas d'absence de haute fréquence, un signal indiquant une anomalie est envoyé en 218. Les signaux recueillis en 152 et 153 sur le coupleur bidirectionnel 150 sont convertis sous forme numérique, puis le taux d'ondes stationnaires est comparé par le circuit électronique 140 lors de l'étape 211 à une valeur précédemment mémorisée. Il résulte du test 211 que si le rapport d'ondes stationnaires est amélioré, une nouvelle demande de coupure d'émission suivie d'une émission sur la même fréquence, est envoyée au poste 10 à l'étape 212, afin d'essayer une nouvelle combinaison de condensateurs conformément à l'algorithme de recherche. L'organigramme est repris dans ce cas en amont du test 205. Lorsque la nouvelle combinaison de condensateurs ne conduit pas à un rapport d'ondes stationnaires amélioré, c'est que la combinaison précédemment essayée correspondait à la combinaison donnant le meilleur accord, et cette dernière est mémorisée lors de l'étape 213. Ensuite, un signal est envoyé à l'utilisateur lors de l'étape 214 pour indiquer que le meilleur accord a été réalisé pour la fréquence f$_k$ et l'on teste en 215 si la variable k est supérieure à la valeur i donnant le nombre total d'itérations à effectuer. Si la variable k est inférieure à i, elle est incrémentée lors de l'étape 216 et l'organigramme est repris avec cette nouvelle valeur de k en 202, pour demander l'émission du poste 10 sur une nouvelle fréquence. Lorsque la variable k est supérieure à la valeur i, un signal de fin d'apprentissage est envoyé en 217.

Dans l'exemple de réalisation décrit, i = 19 et vingt fréquences différentes sont successivement envoyées par le poste émetteur-récepteur 10 à l'antenne lors de la phase d'apprentissage.

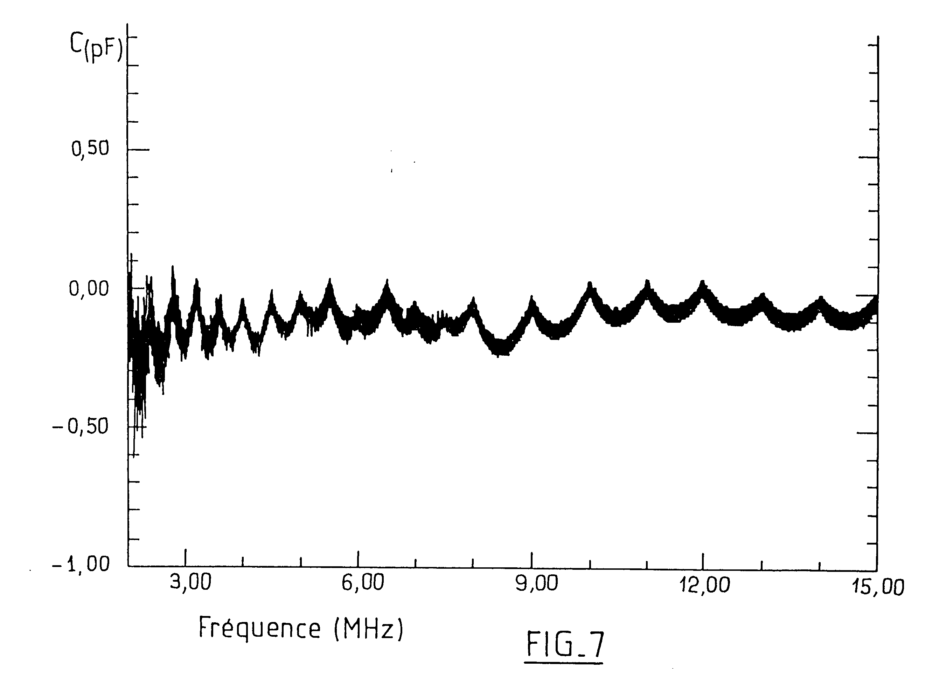

On a représenté sur la figure 7 l'écart en fonction de la fréquence, entre la valeur de capacité théorique (en pF) à mettre en circuit pour obtenir l'accord de l'élément rayonnant et la capacité réelle mise en circuit, pour l'exemple de réalisation décrit. Il faut minimiser cet écart de manière à obtenir, pour toute fréquence, un accord le plus proche possible de l'accord optimal. Le choix des valeurs de capacité des condensateurs est déterminant à cet égard.

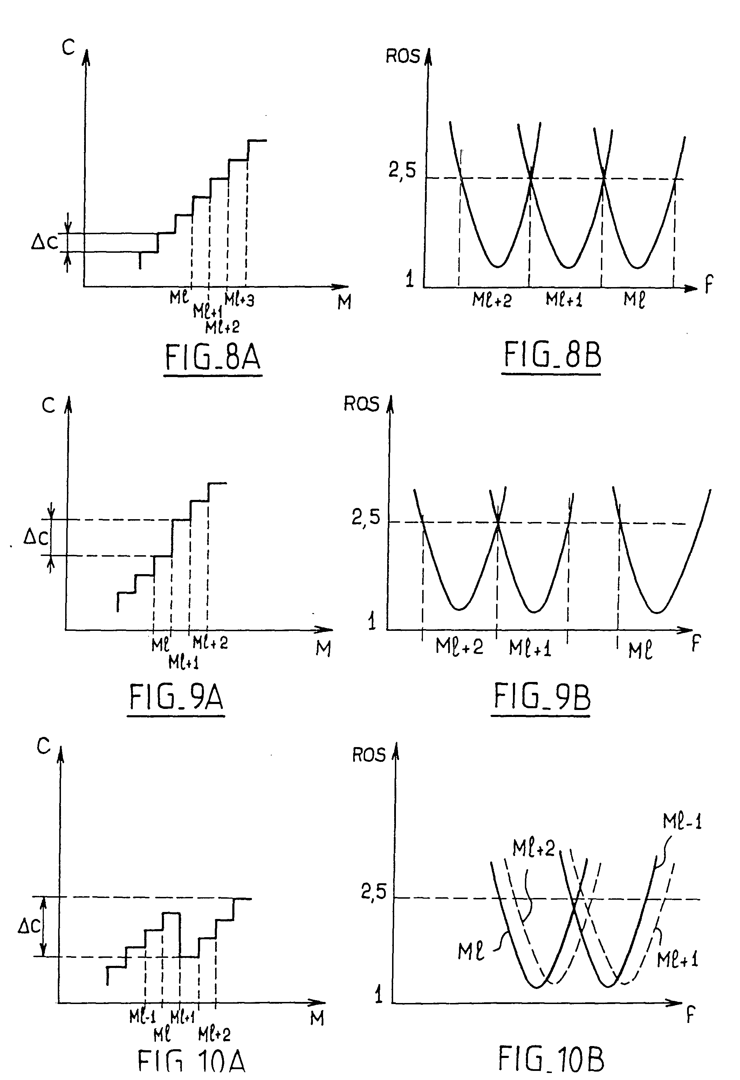

On a représenté sur la figure 8A l'évolution de la capacité mise en circuit pour des valeurs successives du mot binaire commandant les moyens de commutation, c'est-à-dire par exemple des valeurs successives M$_1$, M$_{1+1}$, M$_{1+2}$, de la combinaison de condensateurs mise en circuit, ces différentes valeurs étant respectivement attribuées à des plages de fréquences se succédant.

Si l'on veut que chaque incrément du mot binaire corresponde à une augmentation de la capacité de ΔC = C$_0$, il faut en théorie que la capacité de chaque condensateur C$_g$ (g étant un entier au plus égal à m, m-1 étant le nombre total de condensateurs des premier ou deuxième ensembles de condensateurs susceptibles d'être mis en service) soit égale à la somme des capacités des condensateurs C$_{g-1}$, C$_{g-2}$, .., C$_0$ correspondant aux bits de poids plus faible que celui commandant la mise en service du condensateur Cg, additionnée de la capacité du consensateur C$_0$.

On devrait donc avoir

$$C_g - C_0 = C_{g-1} + C_{g-2} + ... + C_0$$

avec la valeur de capacité de chaque condensateur $C_p$ (p = 0, 1, ..., g) égale en principe à $2^P \cdot C_0$.

On a représenté sur la figure 8B l'évolution du rapport d'ondes stationnaires (ROS) en fonction de la fréquence f, avec mise en circuit, en fonction de celle-ci, de combinaisons successives $M_{1+2}$, $M_{1+1}$, $M_1$ calculées à partir des polynômes $C^j(f)$ précités. L'exemple représenté sur la figure 8B correspond à un cas idéal dans lequel les valeurs de la capacité des condensateurs $C_0$, ..., $C_m$ ou $C_0'$, $C_1'$, ..., $C_m'$ seraient égales à leur valeur nominale, c'est-à-dire que la tolérance de fabrication serait nulle. On cherche à obtenir un rapport d'ondes stationnaires inférieur à un seuil donné (par exemple fixé à 2,5) au passage d'une combinaison à la suivante. Plus ce seuil est faible, plus la valeur de capacité de $C_0$ donnant la résolution des moyens d'accord doit être petite et plus le nombre de condensateurs à utiliser est grand.

Dans la pratique, la valeur de capacité d'un condensateur n'est jamais égale à sa valeur nominale car il existe une tolérance de fabrication. Il serait très coûteux d'utiliser des condensateurs de très grande précision dont l'écart avec la valeur nominale serait très faible.

Si l'on utilise des condensateurs de moindre précision, c'est-à-dire avec une tolérance de 5 % par exemple, il est possible que l'écart $\Delta C$ de la valeur totale de capacité, entre une combinaison $M_1$ correspondant à la mise en circuit de condensateurs $C_{g-1}$, $C_{g-2}$, ... $C_0$ pour une valeur totale de capacité $C_{g-1} + C_{g-2} + ... + C_0$ et la combinaison suivante $M_{1+1}$ (incrément du mot binaire commandant les condensateurs d'un bit) correspondant à la mise en circuit du seul condensateur $C_g$, soit supérieur à $C_0$. On observe alors le saut représenté sur la figure 9A. Cette discontinuité ne permet pas d'avoir un rapport d'ondes stationnaires au plus égal à la valeur limite fixée, lors du passage de la combinaison $M_1$ à la combinaison $M_{1+1}$ comme illustré sur la figure 9B.

Il est également possible, en utilisant des condensateurs de moindre précision, que le passage de la combinaison $M_1$ correspondant à la mise en circuit d'un ensemble de condensateurs $C_{g-1}$, ..., $C_0$ pour une valeur de capacité égale à $C_{g-1} + C_{g-2} + ... + C_0$ à la combinaison suivante correspondant à la seule mise en service du condensateur Cg entraîne un recouvrement des valeurs de capacités, si la valeur réelle du condensateur Cg est inférieure à la somme des capacités $C_{g-1} + C_{g-2} + ... + C_0$. On a illustré ce cas sur la figure 10A. On n'a plus dans ce cas une variation monotone de la capacité en fonction de la valeur du mot binaire commandant la mise en service des condensateurs, contrairement aux cas correspondant aux figures 8A et 9A. Alors, pour certaines fréquences, la combinaison qui sera commutée correspondra à une valeur de la capacité trop éloignée de la valeur théorique, ce qui se traduira par un rapport d'ondes stationnaires supérieur à la valeur limite fixée.

Conformément à une caractéristique avantageuse de l'invention, les condensateurs utilisés sont des condensateurs de faible précision (tolérance 5 % ou plus), peu coûteux, et sélectionnés lors de la fabrication de l'antenne de manière à se placer dans le cas de la figure 10A. Chaque condensateur Cg présente une capacité mesurée inférieure ou égale à la somme des capacités mesurées des condensateurs $C_{g-1}$, $C_{g-2}$, ..., $C_0$.

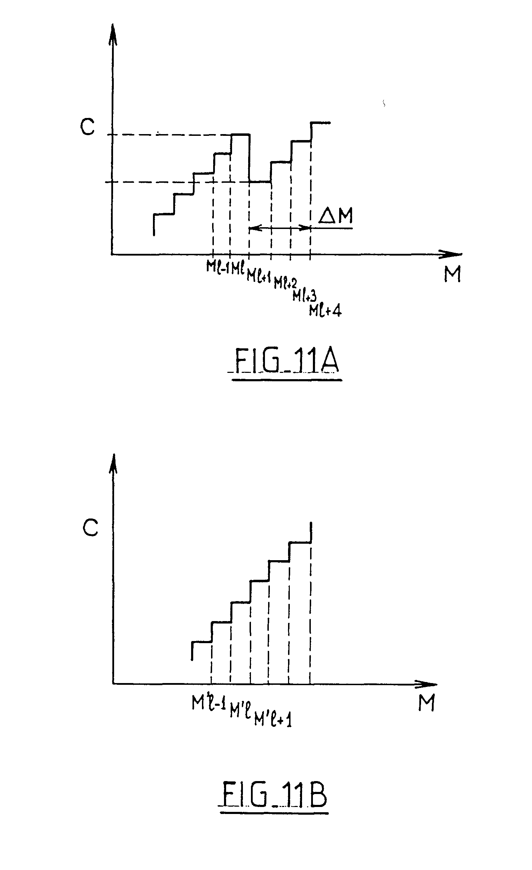

On a représenté sur la figure 11A la valeur de la capacité mise en circuit pour des combinaisons successives de condensateurs $M_{l-1}$, $M_1$, $M_{1+1}$, $M_{1+2}$, $M_{1+3}$, $M_{1+4}$, correspondant aux valeurs de capacités suivantes :

$$C_{g-1} + C_{g-2} + ... + C_1, \; C_{g-1} + C_{g-2} + ... + C_1 + C_0, \; C_g, \; C_g + C_0, \; C_g + C_1$$

$$+ C_0, \; C_g + C_2$$

Puisqu'on choisit le condensateur Cg de manière à avoir $C_g \leq C_{g-1} + C_{g-2} + ... + C_1 + C_0$, il y a un écart $\triangle C = C_g - (C_{g-1} + C_{g-2} + ... + C_0)$ négatif au passage des combinaisons $M_1$ à $M_{1+1}$.

Dans l'exemple de la figure 11A, il faut attendre la combinaison $M_{1+4}$ pour retrouver une valeur de capacité mise en service $C_g + C_2$ supérieure à la valeur de capacité $C_{g-1} + C_{g-2} + ... + C_1 + C_0$ donnée par la combinaison $M_1$.

On détermine expérimentalement, lors de la fabrication de l'antenne, le correctif à apporter lors de chaque passage d'une combinaison correspondant à la mise en service de tous les condensateurs $C_{g-1}$, $C_{g-2}$, ..., $C_1$, $C_0$ à la combinaison correspondant à la mise en circuit du condensateur Cg de rang immédiatement supérieur (et présentant une valeur de capacité mesurée inférieure à la somme $C_{g-1} + C_{g-2} + ... + C_1 + C_0$).

Ce correctif sur la valeur de capacité se traduit par un correctif $\Delta M$ à apporter au mot binaire M(f) afin de commuter des condensateurs supplémentaires de faible valeur permettant de conserver une allure monotone de l'évolution de la capacité en fonction de la valeur du mot binaire (M(f).

Dans l'exemple qui vient d'être décrit, le correctif $\Delta M$ à apporter correspond à la mise en service du condensateur $C_2$ en plus du condensateur $C_g$. Cela revient à mettre en service, lorsque la fréquence évolue, la combinaison $M_{1+4}$ au lieu de la combinaison $M_{1+1}$ qui aurait été normalement mise en service si les valeurs de capacité des condensateurs avaient été rigoureusement égales à leurs valeurs nominales. La transformation à effectuer sur le mot binaire revient ainsi à remplacer la suite de combinaisons $M_{1-1}$, $M_1$, ..., $M_{1+4}$ par une suite $M'_{1-1} = M_{1-1}$, $M'_1 = M_1$, $M'_{1+1} = M_{1+4}$ afin d'obtenir une évolution monotone sans décrochement comme représenté sur la figure 11B.

L'antenne selon l'invention permet de réaliser l'accord de l'élément rayonnant à une cadence compatible avec les modes de trans-mission dits à évasion de fréquence. Après une phase d'apprentissage, l'antenne est prête à fonctionner normalement. En mode d'émission ou de réception, le poste 10 indique à l'antenne la fréquence f sur laquelle il va émettre ou recevoir. Le circuit électronique 140 détermine alors, en fonction de la courbe C(f) approximée par la suite de polynômes Cj(f), la valeur de capacité conduisant à l'accord de l'élément rayonnant pour la fréquence f. Le circuit électronique 140 calcule ensuite, à partir de cette valeur de capacité C(f) la combinaison M(f) à mettre en service pour approcher cette valeur. Dans le cas où les combinaisons calculées correspondent à la mise en service d'un condensateur de valeur $C_p$ inférieure ou égale à $C_{p-1} + C_{p-2} + ... + C_0$ on apporte le correctif $\Delta M$ nécessaire à la combinaison M(f) comme expliqué plus haut, ce correctif $\Delta M$ ayant été mémorisé lors de la fabrication de l'antenne dans le circuit électronique 140.

Le circuit électronique 140 comporte dans l'exemple de réalisation décrit un microcontrôleur et les circuits d'interface nécessaires. L'invention n'est pas limitée à l'exemple décrit. On peut ainsi augmenter ou diminuer le nombre de mesures expérimentales du rapport d'ondes stationnaires effectuées lors de la phase d'apprentissage, ou encore modéliser plus finement par des polynômes différents la courbe donnant l'évolution de la capacité d'accord en fonction de la fréquence.

## Revendications

1. Antenne à accord automatique (100), à relier à un poste émetteur-récepteur (10) apte à émettre successivement une suite de fréquences déterminées $(f_o, f_1...f_i)$, qui comprend un élément rayonnant (20), des moyens d'accord (30) pour l'accorder dans l'une des gammes HF. VHF, UHF, sur l'une quelconque des fréquences (f) du poste (10), ces moyens d'accord (30) comportant un ensemble de condensateurs $(C_o, C_1, ..., C_m : C_o', ..., C_m')$ et des moyens de commutation associés $(K_o, K_1..., K_m : D_o..., D_m)$ permettant de mettre en service la combinaison particulière (M(f)) de condensateurs $(C_0, ..., C_m : C_o',..., C_m')$ correspondant à la valeur de capacité (C(f)) conduisant à l'accord de l'élément rayonnant (20) à ladite fréquence (f), caractérisée en ce que l'élément rayonnant est du type boucle ou demi-boucle, en ce que l'antenne comporte un circuit électronique (140) apte à calculer ladite combinaison (M (f)) à partir d'une suite de valeurs de capacités $(C(f_0), C(f_1),..., C(f_i))$ préalablement mémorisées lors d'une phase d'apprentissage de l'antenne et correspondant respectivement à l'accord de l'élément rayonnant (20) pour une suite de fréquences déterminées $(f_0, f_1, ... f_i)$ envoyées à l'antenne par ledit poste (10) lors de la phase d'apprentissage, ce circuit électronique (140) étant apte à commander, lors de ladite phase d'apprentissage, l'émission successive par le poste de chaque fréquence de ladite suite de fréquences déterminées $(f_o, f_1, ..., f_i)$, et l'antenne comprenant des moyens d'asservissement aptes à agir sur les moyens de commutation $(K_0, K_1, ... K_m)$ pour mettre en service, en fonction de la qualité de l'accord obtenu, la combinaison de condensateurs $(M(f_0); M(f_1) ;... ; M(f_i))$ correspondant au meilleur accord de l'élément rayonnant (20) pour chaque fréquence $(f_0 ; f_1... ; f_i)$, et mémoriser cette combinaison, et en ce que les condensateurs utilisés sont des condensateurs dont la valeur de capacité est connue avec une précision d'au moins 5 % par rapport à la valeur nominale, en ce que l'on choisit la valeur nominale de capacité de chaque condensateur $C_p$ égale $C_o$. $2^p$. où $C_o$ est la valeur du plus petit condensateur utilisé, définissant la résolution des moyens d'accord, chaque condensateur $C_p$ étant choisi en outre de manière à ce que sa valeur de capacité réelle $C_p$ respecte l'inégalité

$$C_p - C_o \leq C_{p-1} + C_{p-2} + ... C_o,$$

et en ce que l'on détermine expérimentalement le correctif à apporter à chaque combinaison de condensateurs pour avoir une suite de valeurs de capacités mises en service variant de façon monotone avec la fréquence.

2. Antenne selon la revendication 1, caractérisée en ce que les moyens d'asservissement comportent un coupleur bidirectionnel (150) agencé pour la mesure du rapport d'ondes stationnaires de l'élément rayonnant (20).

3. Antenne selon l'une des revendications 1 et 2, caractérisée en ce que les moyens de commutation comportent des relais $(K_o..., K_m)$ pour l'accord de l'élément rayonnant (20) lorsque l'antenne fonctionne en émission et des diodes PIN $(D_{m+1}, ... D_n)$ pour l'accord de l'élement rayonnant lorsque l'antenne fonctionne en réception.

4. Antenne selon l'une des revendications 1 à 3, caractérisée en ce que le poste émetteur-récepteur (10) est du type à évasion de fréquence.

## Claims

1. An automatic tuning antenna (100) for connection to a transmitter/receiver station (10) suitable for transmitting successively in a sequence of determined frequencies ($f_0$, $f_1$, ..., $f_i$), which antenna includes a radiating element (20), tuning means (30) for tuning over one of the HF, VHF, and UHF ranges to any of the frequencies (f) of the station (10), said tuning means (30) comprising a set of capacitors ($C_0$, $C_1$, ..., $C_m$; $C_0'$, $C_1'$, ..., $C_m'$) and associated switching means ($K_0$, $K_1$, ..., $K_m$; $D_0$, ..., $D_m$) enabling a particular combination (M(f)) of capacitors ($C_0$, $C_1$, ..., $C_m$; $C_0'$, $C_1'$, ..., $C_m'$) to be put into circuit corresponding to the capacitance (C(f)) that would lead to the radiating element (20) being tuned to said frequency (f), the antenna being characterized in that the radiating element is of the loop or half-loop type, in that the antenna includes an electronic circuit (140) suitable for calculating said combination (M(f)) on the basis of a sequence of capacitances ($C(f_0)$, $C(f_1)$, ..., $C(f_i)$) previously stored during a learning stage of the antenna and correspond respectively to the radiating element (20) being tuned to a sequence of determined frequencies ($f_0$, $f_1$, ..., $f_i$) sent to the antenna by said station (10) during the learning stage, said electronic circuit (140) being suitable, during said learning stage, for controlling successive transmission by the station of each frequency in said sequence of determined frequencies ($f_0$, $f_1$, ..., $f_i$), and the antenna including servo-control means suitable for acting on the switching means ($K_0$, $K_1$, ..., $K_m$), as a function of the quality of the resulting tuning, to put into circuit that combination of capacitors ($M(f_0)$; $M(f_1)$; ...; $M(f_i)$) corresponding to the best tuning of the radiating element (20) at each frequency ($f_0$; $f_1$; ...; $f_i$), and in storing said combination, and in that the capacitors used are capacitors whose capacitances are known with an accuracy of at least 5% relative to their nominal values, in that the nominal value of the capacitance $C_p$ of each capacitor is selected to be equal to $C_0$ x 2P where $C_0$ is the smallest capacitance used, defining the resolution of the tuning means, each capacitor $C_p$ being also selected in such a manner that its real capacitance $C_p$ satisfies the following inequality:

$$C_p - C_0 \leq C_{p-1} + C_{p-2} + ... + C_0$$

and in that the correction to be applied to each combination of capacitors in order to obtain a sequence of capacitances put into circuit that vary monotonically with frequency is determined experimentally.

2. An antenna according to claim 1, characterized in that the servo-control means include a two-way coupler (150) organized to measure the standing wave ratio of the radiating element (20).

3. An antenna according to claim 1 or 2, characterized in that the switching means include relays ($K_0$, ..., $K_m$) for tuning the radiating element (20) when the antenna is operating in transmission, and PIN diodes ($D_{m+1}$, ..., $D_n$) for tuning the radiating element when the antenna is operating in reception.

4. An antenna according to any one of claims 1 to 3, characterized in that the transmitter/receiver station (10) is of the frequency evasion type.

## Patentansprüche

1. Automatisch abstimmbare Antenne (100) zum Verbinden mit einem Sende- und Empfangsgerät (10), das zum aufeinanderfolgenden Senden einer Folge von bestimmten Frequenzen ($f_0$, $f_1$, ..., $f_i$) geeignet ist, welche ein Strahlungselement (20) und Abstimmittel (30) zur Abstimmung in einem der Frequenzbereiche HF, VHF, UHF, auf eine der Frequenzen (f) des Geräts (10) umfassen, wobei die Abstimmittel (30) eine Gruppe von Kondensatoren ($C_0$, $C_1$, ..., $C_m$; $C_0'$,..., $C_m'$) und zugehörige Umschaltmittel ($K_0$, $K_1$, ..., $K_m$; $D_0$, ..., $D_m$) aufweisen, die es erlauben, eine spezielle Kombination (M(f)) von Kondensatoren ($C_0$, ..., $C_m$; $C_0'$,..., $C_m'$) in Betrieb zu nehmen, die einem Kapazitätswert (C(f)) entspricht und zur Abstimmung des Strahlungselements (20) auf die besagte Frequenz (f) führt, dadurch gekennzeichnet, daß das Strahlungselement vom Typ einer Schleife oder einer Halbschleife ist, die Antenne eine elektronische Schaltung (140) aufweist, die geeignet ist, die besagte Kombination (M(f)) zu berechnen, ausgehend von einer Folge von Kapazitätswerten ($C(f_0)$, $C(f_1)$, ..., $C(f_i)$), die zuvor während einer Lernphase der Antenne gespeichert wurden und der Abstimmung des Strahlungselements (20) für eine Folge von bestimmten Frequenzen ($f_0$, $f_1$, ..., $f_i$), welche während der Lernphase vom Gerät (10) zur Antenne gesandt wurden, entsprechen, wobei die elektronische Schaltung (140) geeignet ist, während der Lernphase das aufeinanderfolgende Aussenden jeder Frequenz der Folge von bestimmten Frequenzen ($f_0$, $f_1$, ..., $f_i$) durch das Gerät (10) zu steuern, und die Antenne Mittel zum Regeln umfaßt, die geeignet sind, auf das Umschaltmittel ($K_0$, $K_1$, ..., $K_m$) einzuwirken, um abhängig von der Qualität der erhaltenen Abstimmung die der besten Abstimmung des Strahlungselements (20) für jede Frequenz ($f_0$; $f_1$; ...; $f_i$) entsprechende Kombination der Kondensatoren ($M(f_0)$; $M(f_1)$; ...; $M(f_i)$) in Betrieb zu nehmen und diese Kombination zu speichern, dadurch, daß die verwendeten Kondensatoren solche Kondensatoren sind, deren Kapazitätswert mit einer Präzision von mindestens 5% des Nominalwertes bekannt ist, dadurch, daß man den Nominalwert der Kapazität jedes Kondensators Cp gleich $C_0 \cdot 2^p$ wählt, wobei $C_0$ der Wert des kleinsten verwendeten Kondensators ist, der die Auflösung der Abstimmittel definiert, wobei jeder Kondensator Cp außerdem derart gewählt ist, daß sein reeller Kapazitätswert Cp der Ungleichung

$$C_p - C_0 \leq C_{p-1} + C_{p-2} + ... C_0$$

genügt, und dadurch, daß man experimentell eine, von jeder Kombination von Kondensatoren zu erbringende, Korrektur bestimmt, um eine Folge von in Betrieb genommenen Kapazitätswerten zu haben, die monoton mit der Frequenz variiert.

2. Antenne nach Anspruch 1, dadurch gekennzeichnet, daß die Mittel zum Regeln einen zur Messung des Verhältnisses der stationären Wellen des Strahlungselements (20) eingerichteten bidirektionalen Koppler (150) aufweisen.

3. Antenne nach einem der Ansprüche 1 und 2, dadurch gekennzeichnet, daß die Umschaltmittel Schalter ($K_0$, ..., $K_m$) zur Abstimmung des Strahlungselements (20) umfassen, wenn sich die Antenne in Sendefunktion befindet, und Dioden PIN ($D_{m+1}$, ..., $D_n$) zur Abstimmung des Strahlungselements, wenn sich die Antenne in Empfangsfunktion befindet.

4. Antenne nach einem der Anspruche 1 bis 3, dadurch gekennzeichnet, daß das Sende- und Empfangsgerät (10) vom Frequenzänderungstyp ist.

FIG_1

FIG_2

FIG_3

EP 0 691 738 B1

202

208

213

220

221

| $A_0$ | $B_0$ | $M(f_0)$ |
|-------|-------|----------|
| | $\vdots$ | |
| $A_i$ | $B_i$ | $M(f_i)$ |

FIG_4

FIG_5

$d_0$

$d_1$

$t_3$ $d_3$ $t_4$

FIG.6

FIG_7

EP 0 691 738 B1

FIG. 8A

FIG. 8B

FIG. 9A

FIG. 9B

FIG. 10A

FIG. 10B

FIG. 11A

FIG. 11B